# EUROPÄISCHE PATENTANMELDUNG

(11) **EP 1 998 594 A2**
(43) Veröffentlichungstag der Anmeldung: **03.12.2008**
(21) Anmeldenummer: 08104097.4
(22) Anmeldetag: 26.05.2008
(51) Int. Cl.: H04R 25/02

(54) **Hörgerätbauelementeträger mit Batterieaussparung**

(30) Priorität: 30.05.2007 DE 102007025080
(71) Anmelder: Siemens Medical Instruments Pte. Ltd., Singapore 139959 (SG)
(72) Erfinder: Kasztelan, Thomas, 12107 Berlin (DE)
(74) Vertreter: Maier, Daniel Oliver

(57) **Zusammenfassung**

Der Aufbau eines Hörgeräts soll vereinfacht und verkleinert werden. Dazu wird ein Hörgerätebauelementeträger (10) vorgeschlagen mit einer Aussparung (14), die einen Boden (15) aufweist und in die eine Batterie (17) einsetzbar ist, so dass die Batterie (17) lateral in der Hauptausdehnungsebene des Hörgerätbauelementeträgers (10) durch die Wände der Aussparung (14) und in Einsetzrichtung durch den Boden (15) fixiert ist. Ein Batteriekontakt (16) ist in der Aussparung (14) auf dem Boden (15) angeordnet. Mit einem derartigen Träger kann auf eine separate Batteriehalteeinrichtung verzichtet und außerdem eine impedanzarme Kopplung der Batterie an einem Verstärker erreicht werden.

## Beschreibung

Die vorliegende Erfindung betrifft einen Hörgerätbauelementeträger, auf dem elektronische Komponenten eines Hörgeräts befestigt und kontaktiert sind.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO) und In-dem-Ohr-Hörgeräte (IdO), z.B. auch Concha-Hörgeräte oder Kanal-Hörgeräte (CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

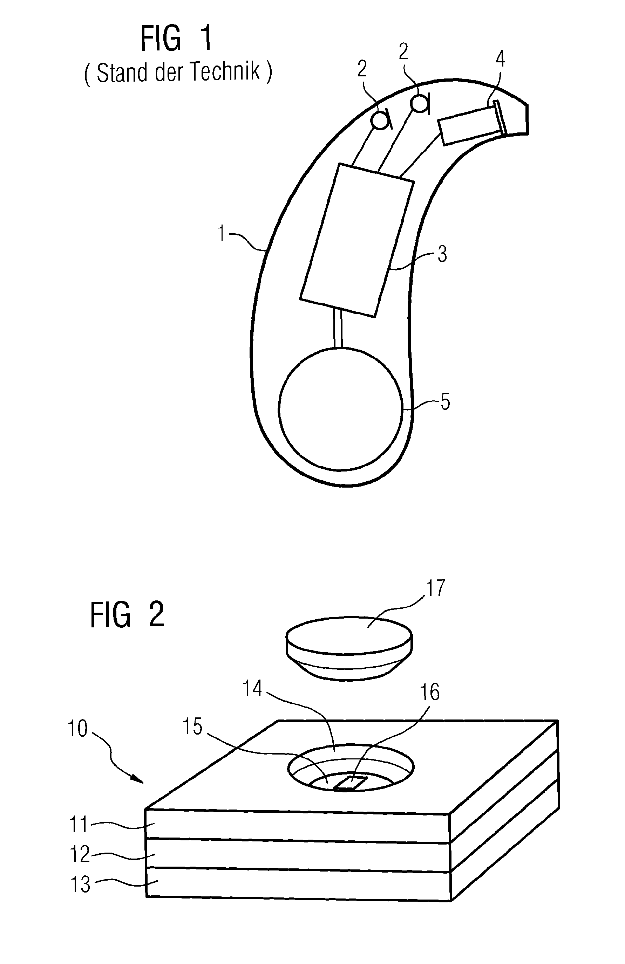

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Stromversorgung des Hörgeräts und insbesondere die der Signalverarbeitungseinheit 3 erfolgt durch eine ebenfalls ins Hörgerätegehäuse 1 integrierte Batterie 5.

Üblicherweise wird die Batterie eines Hörgeräts in einem separaten Batteriefach gehalten und dort kontaktiert. Bei IdO-Hörgeräten befindet sich das Batteriefach in der Regel am sogenannten "Faceplate". Der Batteriefachdeckel, der einen Öffnungshebel aufweist, liegt damit nicht am Gehörgang an. Die anderen Elektronikkomponenten des Hörgeräts sind dann entsprechend um das Batteriefach anzuordnen. Dies gilt insbesondere für die Mikrofone, den Hörer und die Verstärkerplatine. Durch diese Vorgaben kann das Ziel, eine möglichst kleine Bauform zu erreichen, nur bis zu einem gewissen Grad erreicht werden.

Aus der Druckschrift EP 0 684 749 A2 ist ein In-dem-Ohr-Hörgerät bekannt, in dessen Deckel eine Batterie eingesetzt werden kann. Der Deckel weist hierzu eine entsprechende Aussparung auf und es ist am Boden der Aussparung ein Batteriekontakt vorgesehen.

Darüber hinaus beschreibt die Druckschrift US 7 201 996 B1 einen Tongenerator für ein tragbares Gerät. Ein Lautsprecher und eine Batterie werden gemeinsam von einem Gehäuse gehalten.

Schließlich offenbart die Druckschrift EP 0 971 410 A2 ein Modul bestehend aus einem integrierten Schaltkreis und einer Knopfbatterie. Auf der Batterie ist eine Polyimidschicht aufgetragen, die als Träger für den integrierten Schaltkreis dient.

Die Aufgabe der vorliegenden Erfindung besteht somit darin, die Größe der Bauform eines Hörgeräts weiter zu reduzieren.

Erfindungsgemäß wird diese Aufgabe gelöst durch einen Hörgerätbauelementeträger, der als Leiterplatte ausgeführt ist, umfassend eine Aussparung, die einen Boden aufweist und in die eine Batterie einsetzbar ist, so dass die Batterie lateral in der Hauptausdehnungsebene des Hörgerätbauelementeträgers durch die Wände der Aussparung und in Einsetzrichtung durch den Boden fixiert ist, und einen Batteriekontakt, der in der Aussparung auf dem Boden angeordnet ist.

In vorteilhafter Weise kann somit auf ein spezielles Batteriefach bzw. eine eigene Halterung der Batterie verzichtet werden. Außerdem kann das Volumen des ohnehin vorhandenen Hörgerätbauelementeträgers besser genutzt werden.

Vorzugsweise besteht der erfindungsgemäße Hörgerätbauelementeträger aus mindestens zwei Schichten, wovon eine eine rundliche Bohrung besitzt und eine andere den Boden mit dem Batteriekontakt bildet. Durch diese Mehrschichtbildung kann die Batterieaufnahme leicht hergestellt werden. Es ist nämlich lediglich in einer Schicht eine Bohrung und in der darunter liegenden Schicht ein Batteriekontakt vorzusehen.

Weiterhin vorteilhaft ist, wenn der Hörgerätbauelementeträger als keramische Mehrschicht-Leiterplatte ausgebildet ist. Insbesondere kann der Träger mit der LTCC^{®}-Technologie (Low Temperature Cofired Ceramic) hergestellt werden, wobei der keramische Trägerwerkstoff im ungebrannten Zustand den Wünschen entsprechend geformt wird.

Alternativ kann der Hörgerätbauelementeträger als Dickfilmlaminat oder Glasfaserharzlaminat gebildet sein. Dabei werden Technologien der Chipherstellung bzw. der Leiterplattenherstellung genutzt.

Der Hörgerätbauelementeträger kann ferner einen Hörgeräteverstärker tragen, welcher mit dem Batteriekontakt elektrisch verbunden ist. Damit kann ein impedanzarmer Anschluss der Batterie an den Verstärker realisiert werden.

Entsprechend einer anderen Weiterbildung des Hörgerätbauelementeträgers ist an dessen Oberfläche eine Kontaktfeder angelötet, die einen zweiten elektrischen Kontakt zu der in die Aussparung einzusetzenden Batterie bildet. Diese Kontaktfeder kann gleichzeitig als Deckel der Aussparung dienen, so dass die Batterie in der Aussparung ohne weitere mechanische Hilfsmittel gehalten wird.

Wie bereits den vorhergehenden Passagen zu entnehmen ist, wird der geschilderte Hörgerätbauelementeträger vorzugsweise in einem Hörgerät eingesetzt, das eine Batterie, die in die Aussparung eingesetzt ist, und einen Batteriefachdeckel, der einen weiteren Batteriekontakt besitzt und die dem Boden abgewandte Seite der Batterie in einem geschlossenen Zustand kontaktiert, aufweist. Damit können für die weitere Kontaktierung der Batterie übliche Kontakttechnologien verwendet werden.

Die vorliegende Erfindung ist anhand der beigefügten Zeichnungen näher erläutert, in denen zeigen:
- FIG 1: den prinzipiellen Aufbau eines Hörgeräts mit seinen wesentlichen elektronischen Komponenten und
- FIG 2: einen erfindungsgemäßen Hörgerätbauelementeträger mit Batterieaussparung.

Das nachfolgend näher geschilderte Ausführungsbeispiel stellt eine bevorzugte Ausführungsform der vorliegenden Erfindung dar.

FIG 2 zeigt einen Teil eines beispielhaften Hörgerätbauelementeträgers 10. Dieser ist hier in LTCC^{®}-Technologie aufgebaut und besitzt drei Schichten: Eine erste Schicht 11, eine zweite Schicht 12 und eine dritte Schicht 13. Die Anzahl der Schichten ist grundsätzlich beliebig, beträgt jedoch mindestens zwei.

Die erste Schicht 11, in FIG 2 die oberste Schicht, ist mit einer Aussparung bzw. Vertiefung 14 versehen. Diese Aussparung 14 reicht durch die komplette erste Schicht, so dass ein Ausschnitt 15 der zweiten Schicht 12 offen liegt. In diesem Abschnitt 15 ist ein Batteriekontakt 16 platziert. Der Batteriekontakt 16 ist in oder an der zweiten Schicht 12 mit einem geeigneten Leiter verbunden.

In oder auf dem Bauelementeträger 10 befinden sich elektrisch kontaktiert elektronische Bauelemente eines Hörgeräts. Diese sind in FIG 2 nicht dargestellt. Derartige Bauelemente sind insbesondere ein Verstärkerchip, ein Rechner, ein Speicher, Treiber und dergleichen, sofern notwendig. Die Verschaltung dieser Bauelemente erfolgt durch den als Mehrschicht-Leiterplatte (multilayer board) ausgebildeten Bauelementeträger 10. Alternativ kann dieser LTCC^{®}-Träger auch mit Dickfilm- oder Glasfaserharzlaminat-Technologie aufgebaut werden.

In die Aussparung 14 wird eine Batterie 17 eingesetzt. Diese besitzt in dem Beispiel von FIG 2 die typische Form einer Knopfzelle. Die Aussparung 14 weist eine entsprechende negative Kontur auf, so dass die Batterie in eingesetztem Zustand lateral, d.h. senkrecht zur Einsetzrichtung bzw. in der Hauptausdehnungssebene des Trägers 10 fixiert ist. In Einsetzrichtung ist die Batterie 17 durch die zweite Schicht 12 bzw. den darauf befindlichen Batteriekontakt 16 gehalten. Ein Halt in der Einsetzrichtung kann auch dadurch gewährleistet sein, dass die Aussparung 14 eine konische Kontur, wie beispielsweise das Unterteil der Batterie 17 besitzt. Hierdurch kann der Druck auf den Batteriekontakt 16 in gewünschter Weise eingestellt werden. Eine derartige Kontur lässt sich beispielsweise durch einen Laser oder mechanisch in der "grünen" (= ungebrannten) Folie realisieren. Die flexiblen Keramikfolien werden dann nach dem Formen beispielsweise mit bewährter Dickschichttechnik bedruckt, so dass die gewünschten Leiterbahnen auf der Oberfläche oder zwischen den Schichten des Trägers 10 erreicht werden. Anschließend werden die bedruckten Keramikfolien laminiert und bei z. B. 900°C gesintert, wodurch sich ein 3-dimensional vernetzter Multilayer-Träger aus Keramik ergibt, welcher als Verstärkersubstrat verwendet werden kann. In FIG 2 sind die Leiterbahnen der Übersicht halber nicht eingezeichnet.

Der oben dargestellte Hörgerätbauelementeträger 10 zeigt eine impedanz- bzw. induktivarme Anbindung der Batterie 17 zu einem (nicht dargestellten) Verstärker. Da außerdem keine spezielle Batteriehalterung notwendig ist, wird in vorteilhafter Weise eine Platzeinsparung erzielt. Die Batterie 17 lässt sich beispielsweise mit einem Schließer des Batteriefachs oder mit einer auf der Trägeroberfläche angelöteten Feder fixieren und kontaktieren.

Ein weiterer Vorteil des erfindungsgemäßen Trägeraufbaus mit Batterieeinsparung besteht darin, dass nur ein kleines magnetisches Störfeld von den kurzen Batteriekontakten ausgeht. Dies ist besonders günstig bei Telefonspulenanwendungen.

## Patentansprüche

1. Hörgerätebauelementeträger (10) **gekennzeichnet durch**
- eine Aussparung (14), die einen Boden (15) aufweist und in die eine Batterie (17) einsetzbar ist, so dass die Batterie (17) lateral in der Hauptausdehnungsebene des Hörgerätbauelementeträgers (10) **durch** die Wände der Aussparung (14) und in Einsetzrichtung **durch** den Boden (15) fixiert ist, und
- einen Batteriekontakt (16), der in der Aussparung (14) auf dem Boden (15) angeordnet ist.

2. Hörgerätbauelementeträger (10) nach Anspruch 1, der aus mindestens zwei Schichten (11, 12, 13) besteht, wovon eine eine rundliche Bohrung als Aussparung (14) besitzt und eine andere den Boden (15) mit dem Batteriekontakt (16) bildet.

3. Hörgerätbauelementeträger (10) nach Anspruch 1 oder 2, der als keramische Mehrschicht-Leiterplattte ausgebildet ist.

4. Hörgerätbauelementeträger (10) nach Anspruch 2, der als Dickfilmlaminat oder Glasfaserharzlaminat gebildet ist.

5. Hörgerätbauelementeträger (10) nach einem der vorhergehenden Ansprüche, der einen Hörgeräteverstärker trägt, welcher mit dem Batteriekontakt (16) elektrisch verbunden ist.

6. Hörgerätbauelementeträger (10) nach einem der vorhergehenden Ansprüche, an dessen Oberfläche eine Kontaktfeder angelötet ist, die einen zweiten elektrischen Kontakt zu der in die Aussparung (14) einzusetzenden Batterie (17) bildet.

7. Hörgerät mit einem Hörgerätbauelementeträger (10) nach einem der Ansprüche 1 bis 5 mit einer Batterie (17), die in die Aussparung (14) eingesetzt ist, und einem Batteriefachdeckel, der einen weiteren Batteriekontakt besitzt und die dem Boden (15) abgewandte Seite der Batterie (17) in einem geschlossenen Zustand kontaktiert.
